# EUROPEAN PATENT SPECIFICATION

(11) **EP 2 963 679 B1**
(45) Date of publication and mention of the grant of the patent: **12.09.2018**
(21) Application number: 15175256.5
(22) Date of filing: 03.07.2015
(51) Int. Cl.: H01L 23/373, B32B 15/00, C09J 7/00, G06F 1/20, B32B 7/12, B32B 15/04, C09J 7/35, C09J 7/26, F28F 13/18, H01L 23/42

(54) **HEAT RADIATION SHEET**
WÄRMESTRAHLUNGSFOLIE
FEUILLE DE RAYONNEMENT DE CHALEUR

(30) Priority: 04.07.2014 KR 20140083597
(43) Date of publication of application: 06.01.2016
(73) Proprietor: Innochips Technology Co., Ltd., Gyeonggi-Do 425-852 (KR)
(72) Inventor: Noh, Tae Hyung, Gyeonggi-Do 429-906 (KR); Park, In Kil, Gyeonggi-Do 463-831 (KR); Kim, Dae Kyum, Ansan-Si Gyeonggi-Do 425-905 (KR)
(74) Representative: Michalski Hüttermann & Partner Patentanwälte mbB

(56) References cited:
- EP-A1- 2 747 536
- KR-A- 20140 019 737
- US-A1- 2010 172 101
- US-A1- 2011 030 938

## Description

### BACKGROUND

The present disclosure relates to a heat-radiating sheet, and more particularly, to a heat-radiating sheet which is installed in an electronic device and externally releases heat generated inside.

Generally, when electronic devices such as computers and personal mobile devices are unable to externally dissipate excessive heat generated therein, critical problems for system stability, etc. may occur. Moreover, heat generated inside electronic devices may decrease product lifespan, cause failure or malfunction, and in severe cases, may be a cause of explosion or fire. In particular, since current electronic devices are becoming increasingly thinner, multi-featured, and high-performing, heat generated by various internal circuit components must quickly be released externally to prevent such electronic devices from being damaged by the heat. Accordingly, heat-radiating sheets are provided inside electronic devices.

An example of a related art heat-radiating sheet is disclosed in Korean Patent No. 10-0721462. The radiating sheet of the related art includes a thermally conductive metal sheet, and an adhesive foam sheet disposed on at least a surface of the metal sheet. However, since the adhesive foam sheet is attached to a surface of the disclosed heat-radiating sheet, the heat-radiating sheet is thick, and thus usage thereof is difficult in electronic devices which are thin, such as portable electronic devices. A further sheet is disclosed in the KR 2014 0019737

### SUMMARY

The present disclosure provides a heat-radiating sheet which may be reduced in thickness, and thus may be used in an electronic device which is thin.

The present disclosure also provides a heat-radiating sheet in which thermal conductivity may be improved while the thickness is reduced.

In accordance with an exemplary embodiment, a heat-radiating sheet includes a heat-radiating layer having a porous structure with multiple pores; a filler including multiple thermally conductive particles and filling the pores inside the heat-radiating layer; and an adhesive layer disposed on at least one surface of the heat-radiating layer.

In an embodiment, a metal layer may be disposed on the other surface of the heat-radiating layer.

In an embodiment, the heat-radiating layer may be formed through the accumulation of nanofibers.

In an embodiment, the heat-radiating layer may have a porosity of between approximately 20% and 80%.

In an embodiment, the filler may be provided through mixing a thermally conductive polymer material and the thermally conductive particles.

In an embodiment, the filler may be formed through immersing the heat-radiating layer in a mixture in which the thermally conductive polymer material and the thermally conductive particles are mixed in a solvent.

In an embodiment, the mixture may include approximately 30 to 60 wt% of the polymer material and approximately 1 to 30 wt% of the thermally conductive particles.

In an embodiment, the adhesive layer may be formed as a porous structure with multiple pores.

In an embodiment, the thermally conductive particles may also be included in the multiple pores of the adhesive layer.

### BRIEF DESCRIPTION OF THE DRAWINGS

Exemplary embodiments can be understood in more detail from the following description taken in conjunction with the accompanying drawings, in which:
FIG. 1 is a cross-sectional diagram illustrating a heat-radiating sheet in accordance with an exemplary embodiment; and
FIG. 2 is a cross-sectional diagram illustrating a heat-radiating sheet in accordance with another exemplary embodiment.

### DETAILED DESCRIPTION OF EMBODIMENTS

Hereinafter, specific embodiments will be described in detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art.

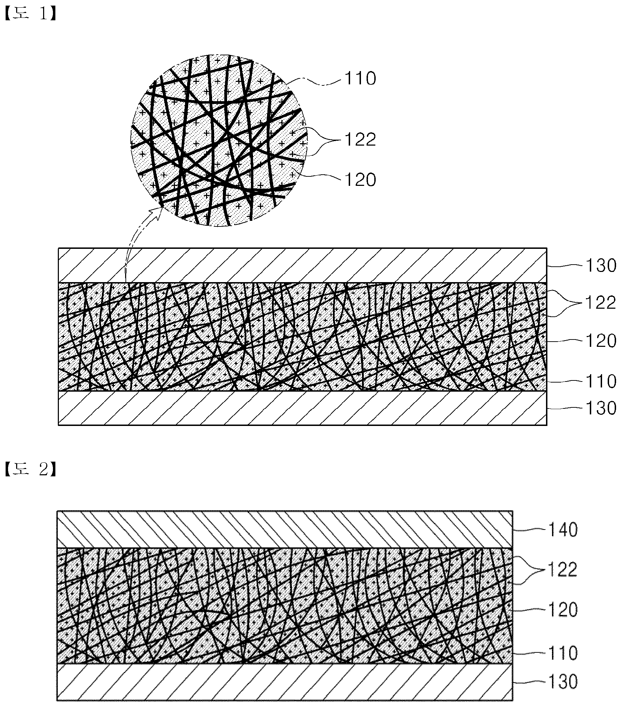

FIG. 1 is a cross-sectional diagram illustrating a heat-radiating sheet in accordance with an exemplary embodiment of the inventive concept.

Referring to FIG. 1, a heat-radiating sheet in accordance with an exemplary embodiment of the inventive concept may include a heat-radiating layer 110 having a porous structure with multiple pores; a filler 120 including multiple thermally conductive particles 122 and filling the pores inside the heat-radiating layer 110; and an adhesive layer 130 disposed on at least one surface of the heat-radiating layer 110.

The heat-radiating layer 110 may be formed as a porous structure having multiple pores therein. The heat-radiating layer 110 may have, for example, a thickness of approximately 0.1 to 0.5 mm and a porosity of approximately 20 to 80%. Here, when the heat-radiating layer 100 has a porosity of less than 20%, there is a low distribution of filler 120 filling the pores, and thus effectiveness in conducting heat may be very low. When the porosity is 80% or greater, there is an excess of pores, and thus there may be difficulty in forming the heat-radiating layer 110. The heat-radiating layer 110 is formed through the accumulation of nanofibers, and pores, which are formed between the nano-sized fibers, may be nano-sized or larger according to the thickness, porosity, etc. of the heat-radiating layer 110. The heat-radiating layer 110 may be formed of a thermally conductive material, and may be formed by using, for example, carbon, carbon nanotubes, etc.. Moreover, to form the heat-radiating layer 110 as a porous structure, the heat-radiating layer 110 may be formed through, for example, electro spinning. Thus, thermally conductive polymer material and solvent may be mixed at a given ratio to form a spinning solution which is then electrospun to produce nano-sized fibers. The heat-radiating layer 110 having a porous structure may be formed when a given thickness of the fibers is produced. For example, nanofibers may be produced through mixing polyacrylonitrile (PAN) and iron acetylacetate (Fe(Acc)₃), a catalyst used for producing carbon nanotubes, at a 2:1 ratio to obtain a mixture; producing a dimethylformamide (DMF) solution which includes 10 wt% of the obtained mixture; and electrospinning the dimethylformamide solution at 30 kV, from a distance of 30 cm. Such an electrospinning apparatus, used to form the heat-radiating layer 110 as described, may include, for example, a high-voltage supply, an electrode for the supplying of power, a pump for supplying polymer solution, a nozzle tip having the function of a spinneret, and a collector which collects fibers. By using the pump, polymer solution is discharged through the nozzle at a constant rate. Concurrently, one electrode connects the high-voltage supply to the nozzle tip so that the polymer solution being physically discharged is electrically charged through the injection of an electrical charge thereto, and the other electrode is connected to the collector, thus grounding the collector. Due to surface tension, polymer solution which is discharged through the nozzle tip takes a half-spherical shape, and when a high voltage of approximately 0 to 30 kV is applied to the nozzle tip, the liquid polymer drop is stretched into a conical funnel due to static electrical repulsive forces between surface charges, and coulombic forces which are applied by external electrical fields. Specifically, when an electrical field of a given strength is applied to the nozzle tip which is in contact with the polymer solution, a positive or negative charge continues to be accumulated in the polymer solution, and as repulsive forces between the same charges overcome the surface tension of the polymer solution, the polymer solution at the nozzle tip is spun and stretched into a Taylor cone-shaped half-spherical jet, and fibers are collected towards the collector that is charged with the opposite charge or grounded. During the spinning process, fine fibers which are randomly oriented on the top portion of the collector may be obtained when stretching and evaporation of the solution occur concurrently, prior to the liquid jet reaching the collector. As was described, nanofibers may be formed through electrospinning using a spinning solution, and the heat-radiating layer 110 having multiple pores may be formed when nanofibers are accumulated. Since the heat-radiating layer 110 is formed through electro spinning, the thickness, porosity, and pore size thereof are determined by the spun amount of spinning solution. Thus, there is an advantage of easily obtaining a desired thickness of the heat-radiating layer 110. Moreover, since the heat-radiating layer 110 is formed by accumulating nanofibers through a spinning method, the heat-radiating layer 110 may be formed to have multiple pores without an additional process, and the size of pores may be controlled according to the amount of spinning solution used.

The filler 120 includes thermally conductive particles 122 and fills the inside of the heat-radiating layer 110, and thus may further improve the heat-conducting property of the heat-radiating sheet. The filler 120 may include the polymer material and the thermally conductive particles 122. That is, the filler 120 may be formed of polymer material in which thermally conductive particles 122 have been dispersed. The polymer material may include ethylene resin, propylene resin, vinyl chloride resin, styrene resin, carbonate resin, ester resin, nylon resin, silicone resin, imide resin, etc. Thermally conductive metals having good thermal conductivity such as nickel (Ni), copper (Cu), and silver (Ag); thermally conductive ceramics; etc. may be used as the thermally conductive particles (122). Obviously, any other material, which is not among those described above and has a thermal conductivity that is higher than that of air, may also be used. The thermally conductive particles 122 may have a size - for example, a nano size - that is smaller than the pores which are inside the heat-radiating layer 110. When the multiple pores in the heat-radiating layer 110 are filled with the filler 120 which includes nano-sized thermally conductive particles 122, the thermal conductivity may be further improved in comparison to using only the heat-radiating layer 110 having a porous structure. In particular, by providing the filler 120 which includes thermally conductive particles 122 having a thermal conductivity that is higher than the pores, and thus higher than air, in the heat-radiating layer 110, the thermal conductivity may be further improved when compared with being composed only of the heat-radiating layer 110. To disperse the filler 120 within the pores disposed in the heat-radiating layer 110, the heat-radiating layer 110 may be immersed in a mixture in which the polymer material which includes the thermally conductive particles 122 has been mixed in a designated solvent. For example, silicone resin and the thermally conductive particles 122 may be mixed in a designated solvent to obtain a mixture, the heat-radiating layer 110 immersed in the obtained mixture, and the solvent dried to disperse the thermally conductive filler 120 within the heat-radiating layer 110. Here, the solvent may include ethyl acetate, methyl ethyl ketone, methylene chloride, tetrahydrofurane, chloroform, etc., each of which may be used alone or in combinations of two or more. The proportion of silicone resin in the mixture may be approximately 30 to 60 wt% of the total weight of the mixture, and the proportion of the thermally conductive particles 122 in the mixture may be approximately 1 to 30 wt% of the total weight of the mixture. The proportion of solvent is substantially equal to the total weight of the mixture excluding the total weight of the silicone resin and thermally conductive particles 122. That is, the proportion of solvent may be approximately 10 to 69 wt% of the total weight of the mixture. When the proportion of silicone resin is below 30 wt%, obtaining a uniform dispersion of the filler 120 in the heat-radiating layer 110 may be difficult, and when the proportion of silicone resin exceeds 60 wt%, dissolving silicon resin in the solvent is difficult, and thus it is difficult for the thermally conductive particles 122 to be uniformly dispersed in the silicone resin. When the content of the thermally conductive particles 122 is less than 1 wt%, the effective improvement in thermal conductivity is negligible, and when the proportion of thermally conductive particles 122 is greater than 30 w%, it is difficult for the thermally conductive particles 122 to be uniformly dispersed throughout the heat-radiating layer 110, and consequently, uniformly radiating heat is difficult.

The adhesive layer 130 is provided to attach the heat-radiating sheet to an electronic device, and is disposed on at least one surface of the heat-radiating layer 110. Thus, the adhesive layer 130 may be disposed on one surface or both surfaces of the heat-radiating layer 110. A double-sided adhesive tape may be used as such an adhesive layer 130. One surface of the double-sided adhesive tape may be attached to one surface of the heat-radiating layer 110, and the other surface, after removing the release liner, may be attached to the electronic device. The adhesive layer 130 may be formed through the same electrospinning method used to form the heat-radiating layer 110. Specifically, the adhesive layer 130 may be formed to a given thickness on at least one surface of the heat-radiating layer 110 through mixing adhesive material and solvent to produce an adhesive solution having a viscosity which is appropriate for electro spinning, and then electrospinning the adhesive solution. Here, rubber, acrylic, silicone, etc. -based adhesive materials may be used as the adhesive material. An apparatus which is the same as the electrospinning apparatus used for electrospinning the heat-radiating layer 110 may be used for forming the adhesive layer 130 through electro spinning. Specifically, by providing a pump for supplying adhesive solution adjacent to the pump for supplying polymer solution which is used in forming the heat-radiating layer 110 and providing a nozzle for spraying the adhesive solution, the adhesive layer 130 may be formed continuously, through electro spinning, after forming of the heat-radiation layer 110. When the adhesive solution is electrospun as described, nanofibers accumulate to form the adhesive layer 130 to a given thickness, and the adhesive layer 130 may be formed as a porous structure. The adhesive material may flow into the pores of the heat-radiating layer 110, thereby increasing the adhesive strength between the heat-radiating layer 110 and the adhesive layer 130. Therefore, instances of the heat-radiating layer 110 releasing from the adhesive layer 130 may be reduced, and thus the reliability of the heat-radiating sheet may be improved. The adhesive material flows into the pores of the heat-radiating layer 110, allowing for a reduced thickness of the adhesive layer 130. Thus, an ultra-thin film heat-radiating sheet may be realized. Thermally conductive particles may also be dispersed within the adhesive layer 130 so that heat-conducting properties through the adhesive layer 130 may be improved. Accordingly, thermally conductive particles may also be added when producing the adhesive solution. The adhesive layer 130, having thermally conductive particles dispersed therein, may be formed through mixing adhesive material, thermally conductive particles, and solvent to obtain a thermally conductive adhesive solution, and then electrospinning the obtained solution. The thermally conductive particles may be the thermally conductive particles 122 which are used in forming the filler 120. Since thermally conductive particles are included within the adhesive layer 130 as described, adhesive properties and thermal conductivity are both realized when attaching the heat-radiating layer 110 to the electronic device, and thus the heat-radiating performance may be improved.

As described above, in a heat-radiating sheet in accordance with an exemplary embodiment of the inventive concept, multiple pores in a heat-radiating layer 110 may be filled with a filler 120 which includes thermally conductive particles 122, and an adhesive layer 130 may be disposed on at least one surface of the heat-radiating layer 110. The heat-radiating sheet, as described, may be attached to, or attached adjacently to a heat-emitting body such as a light-emitting diode (LED), central processing unit (CPU), or integrated circuit (IC), and may quickly disperse heat which is generated therefrom to prevent a localized increase in the temperature of the heat-emitting body. In addition, the heat-radiating layer 110 which has multiple pores is filled with the filler 120 which includes the thermally conductive particles 122, and thereby the thermal conductivity may be further improved.

FIG. 2 is a cross-sectional diagram illustrating a heat-radiating sheet in accordance with another exemplary embodiment.

Referring to FIG. 2, a heat-radiating sheet in accordance with another exemplary embodiment may include a heat-radiating layer 110 having a porous structure with multiple pores; a filler 120 including multiple thermally conductive particles 122 and filling the pores inside the heat-radiating layer 110; an adhesive layer 130 disposed on one surface of the heat-radiating layer 110; and a metal layer 140 disposed on the other surface of the heat-radiating layer 110.

The heat-radiating layer 110 may be formed as a porous structure having multiple pores, and may be realized through mixing polymer material and solvent at a given ratio to produce a spinning solvent, electrospinning the spinning solvent to form nanofibers, and accumulating the nanofibers.

The filler 120 may be obtained through mixing the thermally conductive particles 122 and thermally conductive polymer material at a given ratio with a solvent to produce a mixture, immersing the heat-radiating layer 110 in the mixture and then drying, so that the filler 120 may fill the multiple pores in the heat-radiating layer 110.

The adhesive layer 130 may be an adhesive tape, or be formed through electrospinning a spinning solution which includes an adhesive material, on a surface of the heat-radiating layer 110.

The metal layer 140 may be formed through coating a thermally conductive metal such as nickel (Ni), copper (Cu), or silver (Ag) on one surface of the heat-radiating layer 110. The metal layer 140 may also be formed through attaching a metal foil. When compared to using only the heat-radiating layer 110, the heat-radiating property may be further improved when the metal layer 140 is added. The metal layer 140 may be realized as a metal pattern layer which is coated as a pattern on a surface of the heat-radiating layer 110. When the metal layer 140 is formed as a pattern, the contact surface area is increased, and thereby the efficiency in releasing heat may be increased.

A heat-radiating sheet in accordance with exemplary embodiments of the inventive concept may be formed as a porous structure with multiple pores, such that the heat-radiating sheet may be formed to be thin, and thus may be advantageously applied in electronic devices which are thin.

Moreover, a filler, which includes thermally conductive particles, may fill multiple pores in the heat-radiating layer, to thereby improve the rate at which heat generated from electronic devices is conducted externally.

Furthermore, a metal layer having a high thermal conductivity may be disposed on one surface of a heat-radiating layer which has a porous structure, to thereby further improve thermal conductivity.

Although the heat-radiating sheet has been described with reference to the specific embodiments, it is not limited thereto. Therefore, it will be readily understood by those skilled in the art that various modifications and changes can be made thereto without departing from the spirit and scope of the present invention defined by the appended claims.

## Claims

1. A heat-radiating sheet comprising:
a heat-radiating layer having a porous structure with multiple pores;
a filler including multiple thermally conductive particles and filling the pores inside the heat-radiating layer; and
an adhesive layer disposed on at least one surface of the heat-radiating layer, **characterized in that**, the filler includes thermally conductive particles and a thermally conductive polymer material.

2. The heat-radiating sheet of claim 1, further comprising a metal layer disposed on the other surface of the heat-radiating layer.

3. The heat-radiating sheet of claim 1, wherein the heat-radiating layer is formed through the accumulation of nanofibers.

4. The heat-radiating sheet of claim 3, wherein the heat-radiating layer has a porosity between approximately 20% and 80%.

5. The heat-radiating sheet of claim 1, wherein the mixture includes approximately 30 to 60 wt% of the polymer material and approximately 1 to 30 wt% of the thermally conductive particles.

6. The heat-radiating sheet of claims 1, wherein the adhesive layer is formed as a porous structure with multiple pores.

7. The heat-radiating sheet of claim 6, wherein the thermally conductive particles are also included in the multiple pores of the adhesive layer.

## Patentansprüche

1. Wärmeabstrahlende Folie mit:
einer wärmeabstrahlenden Schicht mit einer porösen Struktur mit mehreren Poren;
einem Füllstoff, der mehrere wärmeleitende Partikel enthält und die Poren im Inneren der wärmeabstrahlenden Schicht füllt; und
einer Haftschicht, die auf mindestens einer Oberfläche der wärmeabstrahlenden Schicht angeordnet ist,
**dadurch gekennzeichnet, dass**
der Füllstoff wärmeleitende Partikel und ein wärmeleitendes Polymermaterial aufweist.

2. Wärmeabstrahlende Folie nach Anspruch 1, ferner mit einer auf der anderen Oberfläche der wärmeabstrahlenden Schicht angeordneten Metallschicht.

3. Wärmeabstrahlende Folie nach Anspruch 1, wobei die wärmeabstrahlende Schicht durch eine Ansammlung von Nanofasern ausgebildet ist.

4. Wärmeabstrahlende Folie nach Anspruch 3, wobei die wärmeabstrahlende Schicht eine Porosität zwischen ungefähr 20% und 80% aufweist.

5. Wärmeabstrahlende Folie nach Anspruch 1, wobei die Mischung etwa 30 bis 60 Gew.-% des Polymermaterials und etwa 1 bis 30 Gew.-% der wärmeleitenden Partikel enthält.

6. Wärmeabstrahlende Folie nach Anspruch 1, wobei die Haftschicht als eine poröse Struktur mit mehreren Poren ausgebildet ist.

7. Wärmeabstrahlende Folie nach Anspruch 6, wobei die wärmeleitenden Partikel auch in den mehreren Poren der Haftschicht enthalten sind.

## Revendications

1. Feuille irradiant de la chaleur comprenant :
une couche irradiant de la chaleur ayant une structure poreuse avec de multiples pores ;
un agent de remplissage incluant de multiples particules thermiquement conductrices et remplissant les pores à l'intérieur de la couche irradiant de la chaleur ; et
une couche adhésive disposée sur au moins une surface de la couche irradiant de la chaleur,
**caractérisée en ce que**,
l'agent de remplissage inclut des particules thermiquement conductrices et un matériau polymère thermiquement conducteur.

2. Feuille irradiant de la chaleur selon la revendication 1, comprenant en outre une couche métallique disposée sur l'autre surface de la couche irradiant de la chaleur.

3. Feuille irradiant de la chaleur selon la revendication 1, dans laquelle la couche irradiant de la chaleur est formée par l'accumulation de nanofibres.

4. Feuille irradiant de la chaleur selon la revendication 3, dans laquelle la couche irradiant de la chaleur a une porosité comprise entre approximativement 20% et 80%.

5. Feuille irradiant de la chaleur selon la revendication 1, dans laquelle le mélange inclut approximativement 30 à 60 wt% du matériau polymère et approximativement 1 à 30 wt% de particules thermiquement conductrices.

6. Feuille irradiant de la chaleur selon la revendication 1, dans laquelle la couche adhésive est formée en tant que structure poreuse avec de multiples pores.

7. Feuille irradiant de la chaleur selon la revendication 6, dans laquelle les particules thermiquement conductrices sont aussi inclues dans les multiples pores de la couche adhésive.
